# FASCICULE DE BREVET EUROPEEN

(11) **EP 4 251 465 B1**
(45) Date de publication et mention de la délivrance du brevet: **19.11.2025**
(21) Numéro de dépôt: 21798421.0
(22) Date de dépôt: 29.09.2021
(51) Int. Cl.: B60L 58/12

(54) **PROCEDE UTILISANT UN COMPTEUR D'ETAT D'UNE BATTERIE**
VERFAHREN MIT EINEM BATTERIEZUSTANDSZÄHLER
METHOD USING A BATTERY STATE COUNTER

(30) Priorité: 24.11.2020 FR 2012039
(43) Date de publication de la demande: 04.10.2023
(73) Titulaire: Stellantis Auto SAS, 78300 Poissy (FR)
(72) Inventeur: BOTCHON, Yannick, 92160 ANTONY (FR); MONDOLONI, Christian, 78180 MONTIGNY LE BRETONNEUX (FR); MORNET, Mickael, 78330 FONTENAY LE FLEURY (FR); PERSEVAL, Herve, 91310 MONTLHERY (FR)
(74) Mandataire: PSIP
(86) Numéro de dépôt international: PCT/FR2021/051684
(87) Numéro de publication internationale: WO 2022/112671

(56) Documents cités:
- EP-A2- 1 151 892
- WO-A1-2010/150076
- US-A1- 2011 231 034
- US-A1- 2019 225 092
- US-B1- 6 335 574

## Description

L'invention concerne un procédé pour des véhicules automobiles ayant des fonctions de sécurité alimentées par une batterie électrique, et plus particulièrement les véhicule à motricité uniquement électrique.

On comprendra par fonction de sécurité, ou dispositif de sécurité, une fonction ou un dispositif qui atteint à la sécurité du conducteur ou des passagers s'ils présentent une défaillance. Cette défaillance, dans le cas présent, est provoquée par une incapacité de la batterie à maintenir une tension suffisante pour cette fonction de sécurité, ou dispositif de sécurité, suite à un appel de courant de cette fonction de sécurité ou dispositif de sécurité, par exemple entre 50 et 130 A, notamment 100 A. On pourra, à titre d'exemple, considérer des fonctions ou dispositifs impliquant cet appel de courant, comme une direction assistée électrique, ou un dispositif de freinage électrique (frein de service, freins de secours, systèmes d'aide au freinage ou anti-patinage par exemple).

On comprendra par mise sous tension du véhicule, dans tout le texte de ce document, une action du conducteur, par exemple via une clé de démarrage dans une position généralement repérée par le sigle +APC, mettant sous tension des calculateurs en vue d'un démarrage du véhicule mais laissant les commandes de motricité inopérantes, le véhicule restant immobile.

On comprendra par démarrage du véhicule, dans tout le texte de ce document, une action supplémentaire du conducteur autorisant le déplacement du véhicule par sa motorisation, et donc consécutivement à la mise sous tension du véhicule, les commandes de motricité devenant opérantes. Par exemple une pédale d'accélération devient opérante suite au passage de la clé de démarrage sur une position de démarrage habituellement repérée par des sigles comme +DEM ou START ou READY et qui se situe un ou plusieurs crans après la position mise sous tension.

On comprendra par arrêt du véhicule, dans tout le texte de ce document, une action inverse à l'action supplémentaire, cette action inverse interdisant le déplacement du véhicule, par exemple signifiant l'intention du conducteur de quitter le véhicule par l'actionnement inverse de la clé de démarrage revenant à la position de mise sous tension ou une position hors tension.

On comprendra par roulage du véhicule, toutes les actions survenant entre l'instant de démarrage et d'arrêt du véhicule.

On connait du document de brevet EP1207083 A1 un procédé détectant une capacité d'une batterie inférieure à un seuil, ce seuil étant dimensionné par exemple pour satisfaire au minimum les besoin d'une direction assistée électrique ou d'un système électrique de freinage. Si cette capacité est inférieure à ce seuil, ce procédé limite la vitesse maximale du véhicule, par exemple.

On connait en outre du document de brevet EP1151892 A2 un procédé conforme au préambule de la revendication 1.

Malheureusement ce procédé présuppose que l'information sur la capacité de la batterie est fiable, sans prendre en compte une quelconque incertitude, et ne priorise pas les mesures. Ainsi la volonté du conducteur est directement contrariée par ces mesures qui peuvent être disproportionnées ou au contraire insuffisantes en présentant alors un risque sécuritaire.

Le but de l'invention est de remédier à ce manque en proposant un procédé fiabilisé et plus juste.

A cet effet, l'invention a pour objet un procédé de contrôle d'une batterie d'un véhicule comprenant la batterie et une unité de contrôle mettant en œuvre le procédé, ce procédé exécutant :
- une étape de diagnostic de la batterie, après un démarrage du véhicule et pour chaque roulage du véhicule,
ce diagnostic donnant un état parmi trois états de la batterie possibles:
- la batterie est capable de répondre à une sollicitation électrique prédéterminée, ou
- la batterie n'est pas capable de répondre à cette sollicitation électrique prédéterminée ou
- une incertitude demeure à répondre à cette sollicitation électrique prédéterminée, et consécutivement à l'étape de diagnostic, le procédé exécute une cinquième étape consistant à incrémenter d'une valeur de un premier compteur si la batterie n'est pas capable de répondre à cette sollicitation électrique prédéterminée, ou à incrémenter d'une valeur de un deuxième compteur si l'incertitude demeure à répondre à cette sollicitation électrique prédéterminée, la cinquième étape réinitialisant le premier et le deuxième compteur à une valeur nulle si la batterie est capable de répondre à une sollicitation électrique prédéterminée, et consécutivement à la cinquième étape, le procédé exécute une sixième étape émettant une alerte maximale si le premier compteur est supérieur ou égal à un premier seuil prédéterminé ou le deuxième compteur est supérieur ou égal à un deuxième seuil prédéterminé.

Ainsi l'invention permet de comptabiliser les différents états de la batterie au cours des roulages successifs, ce qui permet de mieux gérer des alertes et/ou niveaux d'alerte et avec plus de précision, en proportion de l'état réel de la batterie. Le conducteur n'est alors plus contrarié par des alertes et/ou mesures disproportionnées ou au contraire insuffisantes.

Selon un mode de réalisation de l'invention, cette sixième étape émet une alerte intermédiaire si le deuxième compteur est supérieur ou égal à un troisième seuil prédéterminé, et est strictement inférieur au deuxième seuil prédéterminé, et le premier compteur est strictement inférieur au premier seuil prédéterminé.

Selon un mode de réalisation de l'invention, si l'alerte maximale est émise, le procédé :
- active une information de stop à l'intention du conducteur, et/ou
- active un voyant fixe relatif à la batterie pour inciter le conducteur à faire examiner cette batterie, et/ou
- active une coupure d'alimentation d'un consommateur électrique prédéfini comme non prioritaire par rapport à d'autres consommateurs, notamment une fonction de confort vis-à-vis d'une fonction sécuritaire.

Selon un mode de réalisation de l'invention, si l'alerte intermédiaire est émise, le procédé active une information de service à l'intention du conducteur pour l'inciter à minima à recharger la batterie.

D'autres particularités et avantages apparaîtront à la lecture de la description ci-après d'un mode particulier de réalisation, non limitatif de l'invention, faite en référence aux figures dans lesquelles :
**[****Fig 1****]** : est une représentation schématique d'un véhicule à traction électrique, conforme à l'invention;
**[****Fig 2****]** : est un logigramme simplifié représentant le procédé selon un mode de réalisation de l'invention.
**[****Fig 3****]** : représente un exemple de cartographie utilisée par le procédé selon l'invention.

Il est à garder à l'esprit que les figures sont données à titre d'exemples et ne sont pas limitatives de l'invention. Elles constituent des représentations schématiques de principe destinées à faciliter la compréhension de l'invention et ne sont pas nécessairement à l'échelle des applications pratiques. En outre, dans ce qui va suivre, il est fait référence à toutes les figures prises en combinaison. Quand il est fait référence à une ou des figures spécifiques, ces figures sont à prendre en combinaison avec les autres figures pour la reconnaissance des références numériques désignées. Les références des éléments inchangés ou ayant la même fonction sont communes à toutes les figures, et les variantes de réalisation.

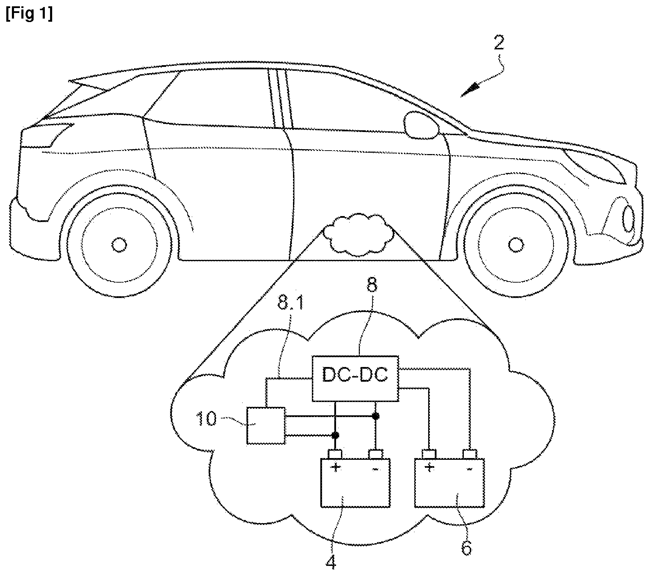

**La** **figure 1** représente schématiquement un véhicule automobile conforme à l'invention et auquel un procédé selon l'invention est appliqué.

Le véhicule automobile 2 est du type à traction électrique, comme par exemple un véhicule électrique pur ou encore un véhicule hybride. Le véhicule automobile 2 comprend une batterie d'accumulateurs électriques basse tension 4, comme par exemple une batterie du type acide-plomb mais pas nécessairement, cette batterie pouvant également être du type lithium-ion. Cette batterie basse tension 4 alimente le réseau de bord du véhicule comme notamment la planche de bord, l'éclairage et la signalisation lumineuse, le contrôle moteur, etc.

Par basse tension on entend une tension inférieure ou égale à 48 volts, celle-ci étant toutefois actuellement couramment de 12 volts. Le véhicule automobile 2 comprend également une batterie d'accumulateurs électriques haute-tension 6 destinée à alimenter un ou plusieurs moteurs électriques de traction du véhicule. La tension aux bornes de cette batterie peut varier entre 100 et 600 volts. Un convertisseur DC-DC (« DC » est un acronyme de « Direct Current », signifiant courant continu) 8 est relié électriquement à la batterie haute-tension 6 et à la batterie basse tension 4 et est configuré pour recharger ladite batterie basse-tension 4 à partir de ladite batterie haute-tension 6. Il permet de convertir la haute-tension de la batterie haute tension 6 en une basse-tension compatible pour recharger la batterie basse tension 4.

Ce convertisseur 8 permet en outre d'alimenter l'ensemble du réseau de bord 12V, en plus de recharger la batterie basse-tension 4.

Dans l'exemple illustré, ce convertisseur 8 est mono directionnel et commandé en tension, mais en variante et notamment pour les véhicules hybrides ce convertisseur 8 peut être bidirectionnel et commandé en tension ou en courant. En situation nominale, la batterie basse-tension 4 n'intervient que lorsque le convertisseur 8 ne suffit pas à alimenter seul le réseau de bord, ou à fournir la puissance requise lors de l'activation des fonctions ou dispositifs sécuritaires, en raison d'une dynamique pas assez rapide du convertisseur 8.

Toujours en référence à la figure 1, le véhicule automobile 2 comprend également une unité de contrôle 10 de batterie basse tension 4. La batterie basse-tension 4 joue en effet un rôle important dans le véhicule en ce qu'elle alimente tout le réseau de bord du véhicule, incluant des fonctions sécuritaires comme le système anti-blocage des freins (couramment appelé ABS pour « Anti-Blocking Sytem), la direction assistée électrique, etc, lorsque, tel que précédemment décrit, la dynamique du convertisseur 8 n'est pas assez rapide pour répondre au besoin de ces fonctions sécuritaires. Pour ces raisons, il est important de pouvoir s'assurer du bon état de fonctionnement de la batterie basse-tension 4 avant d'autoriser le véhicule à se déplacer au-delà d'une certaine vitesse, comme par exemple 30 m/h.

Pour cela, plusieurs sollicitations électriques préalables de la batterie 4, provoquant plusieurs appels de courant successifs, est un moyen de tester une capacité réelle de ladite batterie 4 à fournir une puissance nécessaire à la fonction sécuritaire, c'est-à-dire maintenir une tension minimale prédéterminée pour un appel de courant donné, en évaluant des paramètres tels que la résistance interne Rint, ainsi que la tension minimale du stockeur Umin, atteintes pendant chacun de ces appels de courant.

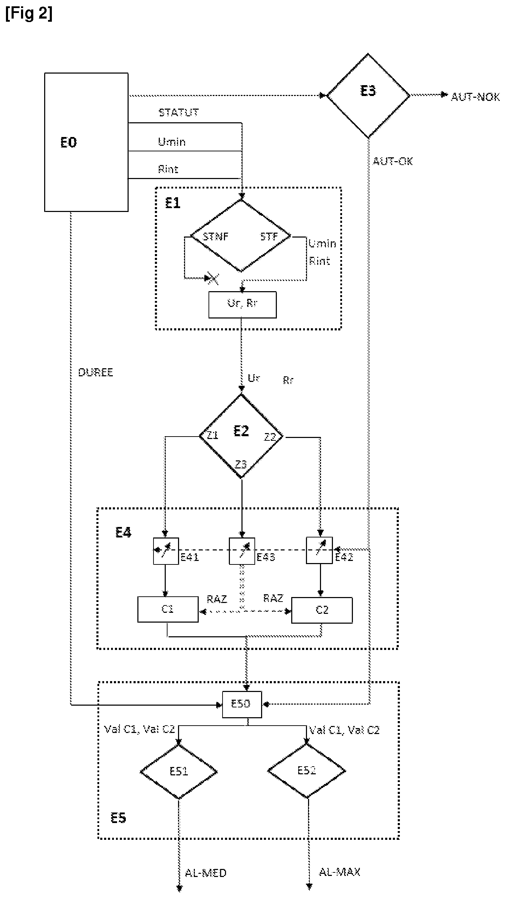

Dans cet exemple de la figure 2, l'unité de contrôle 10 est un moyen de mise en œuvre du procédé selon l'invention, et cette unité de contrôle 10 commande par exemple le convertisseur 8 DC-DC pour réaliser ces sollicitations électriques successives, mais d'autres moyens pour réaliser ces sollicitations électriques successives sont envisageables. Ces moyens de sollicitations électriques sont contrôlés par l'unité de contrôle 10, et peuvent comprendre par exemple une résistance passive connectée, par des moyens de connexion eux aussi pilotés par l'unité de contrôle 10, aux bornes de la batterie 4.

On notera qu'en variante, il peut n'être mis en œuvre qu'une sollicitation électrique.

**La** **figure 2** est un logigramme illustrant le principe de fonctionnement d'un procédé de contrôle selon l'invention, par exemple au moyen de l'unité de contrôle 10.

Cette unité de contrôle 10 comprend par exemple un boîtier d'état de charge de la batterie BECB ou BMS pour l'acronyme en anglais de « battery management system » et/ou d'autres calculateurs, ou être lui-même agencé sous la forme d'une unité (ou calculateur) de contrôle dédiée comprenant un éventuel programme dédié, par exemple. Par conséquent, une unité de contrôle 10, selon l'invention, peut être réalisé sous la forme de modules logiciels (ou informatiques (ou encore « software »)), ou bien de circuits électroniques (ou « hardware »), ou encore d'une combinaison de circuits électroniques et de modules logiciels ».

Le procédé de contrôle de la batterie 4 commence par une première étape E0 de diagnostic de la batterie basse tension 4.

Ce procédé de contrôle d'une batterie 4 d'un véhicule comprenant la batterie 4 et une unité de contrôle 10 mettant en œuvre le procédé, exécute :
- une étape de diagnostic E0, E1, E2, E3 de la batterie 4, après un démarrage du véhicule et pour chaque roulage du véhicule, ce diagnostic donnant un état de la batterie 4 parmi trois états Z1, Z2, Z3 de la batterie 4 possibles:
- la batterie est capable de répondre à une sollicitation électrique prédéterminée Z3, ou
- la batterie n'est pas capable de répondre à cette sollicitation électrique prédéterminée Z1 ou
- une incertitude demeure à répondre à cette sollicitation électrique prédéterminée Z2,
et consécutivement à l'étape de diagnostic, le procédé exécute une cinquième étape E4 consistant à incrémenter d'une valeur de 1 un premier compteur C1 si la batterie n'est pas capable de répondre à cette sollicitation électrique prédéterminée Z1, ou à incrémenter d'une valeur de 1 un deuxième compteur C2 si l'incertitude demeure à répondre à cette sollicitation électrique prédéterminée Z2.

L'étape de diagnostic E0, E1, E2, E3 peut être élaborée à partir de différentes méthodes. Par exemple, elle peut être élaborée à partir d'un modèle prédictif de vieillissement de la batterie, en utilisant comme informations d'entrée un état de charge de la batterie et sa température. Elle peut en variante être élaborée de façon approximative par une simple mesure de la chute de tension de la batterie, cette chute étant comparée à un ou plusieurs seuils, lors de l'actionnement d'un consommateur de courant prédéterminé ou mesuré.

L'étape de diagnostic E0, E1, E2, E3 peut également être conforme, selon une variante préférée, à la description détaillée ci-dessous :

L'étape de diagnostic E0, E1, E2, E3 comprend une première étape E0 comprenant, après une mise sous tension du véhicule, une sous étape initiale optionnelle d'interrogation de besoin de diagnostic de la batterie basse tension. Un tel besoin peut être présent après la mise sous tension du véhicule, et avant de démarrer le véhicule ou de commencer à rouler ou tant que la vitesse du véhicule ne dépasse pas une vitesse limite au-delà de laquelle la sécurité du ou des occupants ne peut plus être assurée sans diagnostic positif de la batterie basse tension 4.

En cas de réponse positive à la sous étape initiale d'interrogation, et après le démarrage du véhicule, la première étape E0 comprend une première sous étape consistant à commander le moyen de sollicitations électriques en mode diagnostic de la batterie basse tension 4. Par exemple, à commander le convertisseur 8 en mode diagnostic de la batterie basse tension 4.

On notera que, avantageusement, l'information de besoin de diagnostic est telle qu'elle autorise l'exécution de la première sous étape à chaque démarrage du véhicule, notamment une unique fois à chaque démarrage du véhicule.

Le procédé exécute ensuite une deuxième sous étape consistant à réaliser le diagnostic de la batterie basse tension 4.

Cette deuxième sous étape :
- provoque plusieurs sollicitations électriques de la batterie 4 à la suite provoquant chacune un appel de courant, et surveillant l'apparition d'un défaut interne à l'unité de contrôle 10,
- puis détermine un couple de valeurs comprenant une tension Umin et une résistance interne Rint de la batterie 4, à partir de chaque appel de courant.

La première étape E0 exécute consécutivement à la deuxième sous étape, une troisième sous étape déterminant un statut STATUT pour chaque couple de valeurs, ce statut prenant un état :
- non fiable STNF si l'appel de courant provoqué par la sollicitation électrique a été trop faible par rapport à un seuil prédéterminé dans un temps imparti, ou si un défaut interne à l'unité de contrôle 10 a été présent durant ce temps imparti,
- fiable STF si l'appel de courant provoqué par la sollicitation électrique a été supérieur ou égal au seuil prédéterminé dans ce temps imparti, et si il n'y a pas eu de défaut interne à l'unité de contrôle 10 durant ce temps imparti.

La ou les sollicitations électriques sont obtenues par exemple de la façon suivante : L'unité de contrôle 10 envoie une consigne de tension de la batterie 4, c'est-à-dire une consigne de tension de diagnostic, appliquée à une entrée 8.1 du convertisseur 8 (figure 1), et cette consigne impose une valeur de tension inférieure à la tension initiale aux bornes de la batterie. Il est avantageux d'ajuster cette consigne à une valeur permettant d'avoir la meilleure précision sur le diagnostic des étapes suivantes. Idéalement cette consigne est une tension inférieure à la tension initiale (c'est-à-dire, avant le passage du convertisseur 8 en mode diagnostic) entre les bornes de la batterie 4. Par exemple, pour une batterie 4 basse tension de 12 V qui, quand elle est chargée et à vide à une tension plus proche de 13V que de 12 V, cette consigne est par exemple comprise entre 10 V et 12 V, notamment 10,6 V.

En variante, et suivant la technologie du convertisseur 8 présente, on pourra commander ce convertisseur 8 par une consigne en courant (un courant de débit vis-à-vis de la batterie 4) à la place de la consigne de tension de diagnostic.

En variante, cette deuxième sous-étape provoque une unique sollicitation électrique.

En variante, ce statut prend un état :
- non fiable STNF si l'appel de courant provoqué par la sollicitation électrique a été trop faible par rapport au seuil prédéterminé dans le temps imparti, ou
- fiable STF si l'appel de courant provoqué par la sollicitation électrique a été supérieur ou égal au seuil prédéterminé dans ce temps imparti.

On comprendra par « l'appel de courant provoqué par la sollicitation électrique a été trop faible par rapport à un seuil prédéterminé » dans tout le texte de ce document, la comparaison de la valeur de la différence entre l'intensité maximale de l'appel de courant dans le temps imparti et l'intensité au début de l'appel de courant, avec le seuil prédéterminé d'intensité. Il est sous-entendu que ce sont des valeurs absolues d'intensité. En outre, ces courants et tensions sont des valeurs prises aux bornes de la batterie 4.

Ce temps imparti est par exemple de 0,05 seconde mais peut être compris idéalement entre 0,04 et 0,1 seconde. Le seuil prédéterminé du courant est par exemple de 60A mais peut être compris idéalement entre 50 A et 130A. Ceci correspond à une sollicitation électrique minimale qui impose une augmentation du courant débité par la batterie 4 de au moins 60A en moins de 0,05 secondes.

On notera que la sollicitation électrique provoque une chute de tension de la batterie basse tension 4 simultanément à l'appel de courant, la tension Umin est alors la tension la plus basse mesurée pendant la sollicitation électrique provoquant cette chute de tension.

La résistance interne Rint est la valeur de cette chute de tension dû à l'appel de courant, divisée par la valeur de la variation du courant dû à l'appel de courant, en considérant que la force électromotrice de la batterie 4 est sensiblement constante.

De façon optionnelle, ce procédé compte le nombre d'états STNF successifs, sur un ou plusieurs roulages par exemple. Ainsi, dès que ce nombre dépasse un seuil, par exemple 6 états STNF successifs, une alerte de service est émise à l'intention du conducteur.

L'étape de diagnostic E0, E1, E2, E3 comprend une deuxième étape E1. Consécutivement à la première étape E0, le procédé exécute la deuxième étape E1, analysant les informations SATUT, Umin, Rint, précédemment déterminées, et fournissant une information vérifiée sur la résistance interne Rint et la tension minimale Umin, atteintes pendant l'appel de courant ayant servi à calculer la résistance interne Rint. Cette deuxième étape E1 consiste à ne conserver que les couples de valeurs (Umin, Rint) associés au statut (STATUT) à l'état fiable (STF), et à déterminer un unique couple de valeurs représentatives (Ur, Rr) à partir des couples de valeurs (Umin, Rint) conservés.

Par exemple, l'unique couple de valeurs représentatives (Ur, Rr) est égal au dernier couple de valeurs (Umin, Rint) conservé.

Par exemple, l'unique couple de valeurs représentatives (Ur, Rr) est la moyenne des couples de valeurs (Umin, Rint) conservés.

On notera que le défaut interne à l'unité de commande, s'il est détecté pendant le temps imparti, force le statut du couple de valeurs associé à non fiable STNF et ce couple de valeurs n'est pas conservé, ou ignoré.

Avantageusement, lorsque le statut passe d'un état fiable STF à non fiable STNF à cause de la présence de ce défaut interne à l'unité de contrôle 10, le procédé ignorera tous les couples de valeurs consécutifs à l'apparition de ce défaut jusqu'à un prochain démarrage du véhicule.

Pour la variante ne comprenant qu'une unique sollicitation électrique, l'unique couple de valeurs représentatives (Ur, Rr) est égal à l'unique couple de valeurs (Umin, Rint). En variante encore, l'unique couple de valeurs représentatives (Ur, Rr) est indisponible si l'unique couple de valeurs (Umin, Rint) issu de l'unique sollicitation électrique est associée au statut non fiable STNF ou s'il est ignoré.

L'étape de diagnostic E0, E1, E2, E3 comprend une troisième étape E2. Consécutivement à la deuxième étape E1, le procédé exécute cette troisième étape E2 qui, à partir d'une cartographie prédéterminée des tensions Umin en fonction des résistances internes Rint comprenant au moins :
- une première zone Z1 correspondant à une tension Umin basse et/ou une résistance interne Rint élevée,
- une troisième zone Z3 correspondant à une tension Umin élevée et/ou une résistance interne Rint faible,
- une deuxième zone Z2, intermédiaire à la première et la troisième zone Z1, Z3, détermine en fonction de la zone Z1, Z2, Z3 dans laquelle se trouve l'unique couple de valeurs représentatives Ur, Rr que :
- la batterie est capable de répondre à une sollicitation électrique prédéterminée si l'unique couple de valeurs représentatives se trouve dans la troisième zone Z3, ou que
- la batterie n'est pas capable de répondre à cette sollicitation électrique prédéterminée si l'unique couple de valeurs représentatives se trouve dans la première zone Z1, ou que
- une incertitude demeure à répondre à cette sollicitation électrique prédéterminée si l'unique couple de valeurs représentatives se trouve dans la deuxième zone Z2.

Ainsi cette cartographie permet d'être représentatif sur la capacité de la batterie 4 à répondre à un appel de courant d'une ou plusieurs fonctions ou dispositifs de sécurité simultanés, telles que précédemment définis.

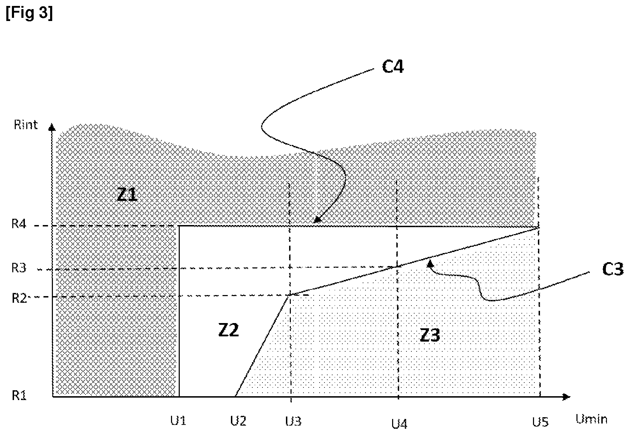

La figure 3 illustre un exemple simplifié d'une telle cartographie. L'axe des abscisses représente la tension Umin dont plusieurs valeurs singulières U1 à U5 sont reportées, l'axe des ordonnées représente la résistance interne Rint dont plusieurs valeurs singulières R1 à R4 sont reportées.

La troisième zone Z3 est la surface entre une première courbe C3 et l'axe des abscisses, cette première courbe coupant l'axe des abscisses au point de tension U2 représenté. Cette première courbe C3 est donc une courbe de la résistance interne Rint en fonction de la tension Umin. Cette courbe C3 est croissante et débute à la valeur de couple U2, R1 et se termine à la valeur de couple U5, R4 avec U5 > U2 et R4>R1. Cette première courbe C3 passe également par deux autres couples singuliers U3, R2 et U4, R3 et est une succession de trois segments, mais elle peut prendre des formes plus complexes. D'une façon générale, R1<R2<R3<R4 et U1<U2<U3<U4<U5.

On notera que ces courbes sont croissantes et non pas strictement croissantes. Ainsi, on inclura dans la définition de courbe croissante, dans tout le texte de ce document, une courbe comprenant une partie constante en abscisse ou en ordonnée, c'est-à-dire une courbe non strictement décroissante.

La première zone Z1 est la surface entre une deuxième courbe C4 et l'axe des ordonnées, cette deuxième courbe C4 coupant l'axe des abscisses au point de tension U1 représenté. Cette courbe C4 est également croissante et débute à la valeur de couple U1, R1 et se termine à la valeur de couple U5, R4, mais ce n'est qu'un exemple simplifié, cette deuxième courbe C4 ne se terminant pas obligatoirement au même point que la première courbe C3. Cette deuxième courbe C4 est ici sous forme d'un échelon, si bien que la première zone Z1 correspond ici à une tension Umin inférieure ou égale à U1 et/ou une résistance interne Rint supérieure ou égale à R4. Mais bien entendu, cette deuxième courbe C4 peut prendre d'autres formes plus complexes.

La deuxième zone Z2 se trouve alors délimitée par cette première courbe C3 d'une part, et cette deuxième courbe C4 d'autre part.

Cette cartographie est prédéterminée par exemple par un plan d'expérience déterminant les valeurs de couples Umin, Rint singuliers pour la construction des courbes C4, C3.

Par exemple, pour une batterie au plomb de 12V, U1 aura une valeur de 10V et U5 une valeur de 16V, et R1 une valeur de 3 mΩ et R4 une valeur de 14 mΩ.

On notera que le point origine des axes n'a pas une valeur nulle, mais correspond à un couple de valeur de 0V, R1, R1 étant non nul (3 mΩ dans notre exemple).

On notera que les appels de courant sont par exemple dans une plage de courant entre 0 et 130 A, notamment entre 50 et 130 A. Pour une batterie 4 basse tension d'un véhicule automobile, ces intensités sont relativement faibles par rapport aux intensités de l'ordre de 300 à 500 A rencontrées pour le démarrage d'un moteur thermique par exemple. Ainsi, pour ces appels de coutant, la tension minimale Umin de la batterie 4 dépend de l'état de la batterie, et non pas de l'intensité de l'appel de courant. C'est pourquoi cette cartographie peut n'avoir que deux dimensions : la tension minimale Umin et la résistance interne Rint.

Pour des appels de courant plus forts, de l'ordre de 300 à 400 A, cette cartographie serait avantageusement à trois dimensions, en rajoutant le courant à la tension minimale Umin et la résistance interne Rint pour être plus juste.

Ainsi en variante :
- lors de la première étape (E0), le procédé détermine l'intensité de l'appel de courant induit au moment de la détermination de la tension (Umin), et
- la cartographie prédéterminée est en outre fonction de l'intensité de l'appel de courant induit, les trois zones (Z1, Z2, Z3) s'étendant à trois volumes, et
- lors de la troisième étape (E2), le procédé détermine en fonction des trois volumes dans lequel se trouve le couple de valeurs représentatives (Umin, Rint) associé à l'intensité de l'appel de courant induit que :
- la batterie est capable de répondre à la sollicitation électrique prédéterminée si le couple de valeurs associé à l'intensité de l'appel de courant induit se trouve dans le troisième volume issu de la troisième zone (Z3), ou que
- la batterie n'est pas capable de répondre à cette sollicitation électrique prédéterminée si le couple de valeurs associé à l'intensité de l'appel de courant induit se trouve dans le premier volume issu de la première zone (Z1), ou que
- une incertitude demeure à répondre à cette sollicitation électrique prédéterminée si le couple de valeurs associé à l'intensité de l'appel de courant induit se trouve dans le deuxième volume issu de la deuxième zone (Z2).

L'étape de diagnostic E0, E1, E2, E3 comprend une quatrième étape E3. Le procédé de la figure 2, selon l'invention, exécute cette quatrième étape E3 dès le démarrage du véhicule, et consistant à :
- démarrer une première temporisation, au démarrage du véhicule, d'une première durée prédéterminée paramétrable et
- émettre un signal d'autorisation AUT-OK à l'issue de cette première temporisation, ce signal d'autorisation AUT-OK étant maintenu seulement pendant une deuxième durée prédéterminée paramétrable.

Ainsi cette autorisation AUT-OK permet d'autoriser, par exemple, l'exploitation de l'unique couple de valeurs représentatives (Ur, Rr) que lorsqu'il est pertinent, c'est-à-dire lorsqu'il est certain que la succession de sollicitations électriques et de mesures de tension Umin et de résistance interne Rint de la batterie 4 pour chaque sollicitation est achevé, et que l'unique couple de valeurs représentatives Ur, Rr est complètement déterminé.

La première durée prédéterminée paramétrable et par exemple entre 4 et 8 secondes, notamment 5 secondes ou encore 7 secondes. Cette première durée prédéterminée paramétrable est supérieure au temps nécessaire pour réaliser la succession de sollicitations électriques.

On notera par exemple, que le temps nécessaire pour la réalisation d'une sollicitation électrique entre le début de l'appel de courant de cette sollicitation et le retour du courant à sa valeur précédant la sollicitation est entre 0,3 et 2 seconde, notamment 0,4 seconde. Ainsi, pour la durée prédéterminée paramétrable de 5 secondes le procédé peut réaliser une série de 3 à 6 sollicitations électriques par exemple.

La deuxième durée prédéterminée permet de dater la mise à jour de l'unique couple de valeurs représentatives Ur, Rr : si elle est top ancienne, alors AUT-OK = faux et le procédé ne prendra pas en compte deux fois de suite les mêmes valeurs de l'unique couple de valeurs représentatives Ur, Rr.

Mais cette quatrième étape E3 n'est pas obligatoire. En outre, un même résultat peut être obtenu de manière différente, par exemple avec une gestion autonome des sollicitations électriques par le convertisseur 8.

Consécutivement à la troisième étape E2, le procédé exécute la cinquième étape E4 précédemment décrite.

En variante, cette cinquième étape consiste à incrémenter d'une valeur de 1 le premier compteur C1 si :
- le signal d'autorisation AUT-OK réalise une transition de faux à vrai E41 et
- la batterie n'est pas capable de répondre à cette sollicitation électrique prédéterminée Z1, c'est-à-dire que le couple de valeurs se trouve dans la première zone Z1,
ou à incrémenter d'une valeur de 1 le deuxième compteur C2 si :
- le signal d'autorisation AUT-OK réalise une transition de faux à vrai E42 et
- l'incertitude demeure à répondre à cette sollicitation électrique prédéterminée Z2, c'est-à-dire si le couple de valeurs se trouve dans la deuxième zone Z2.

Ainsi, à cette cinquième étape E4 le procédé mémorise le nombre de fois que la batterie 4 est détectée comme n'étant pas capable de répondre à cette sollicitation électrique prédéterminée par le premier compteur C1, ou comme étant incertaine à répondre à cette sollicitation électrique prédéterminée par le compteur C2, ces compteurs étant mis à jour une fois en début de chaque roulage. Ainsi en s'appuyant sur l'unique couple de valeurs représentatives Ur, Rr sur plusieurs roulages successifs du véhicule, ce procédé permet de distinguer plusieurs niveaux d'alerte correspondant à différents états de la batterie 4.

On notera que les valeurs prises par ces compteurs sont gardées en mémoire d'un roulage sur l'autre pour être en capacité de fiabiliser le diagnostic de de la batterie sur plusieurs roulages successifs.

En outre, consécutivement à la cinquième étape E4 , le procédé selon l'invention réinitialise le premier et le deuxième compteur C1, C2 à une valeur nulle si :
- le signal d'autorisation AUT-OK réalise une transition de faux à vrai E43 et
- la batterie est capable de répondre à une sollicitation électrique prédéterminée Z3, c'est-à-dire que le couple de valeurs est dans la troisième zone Z3.

En variante, consécutivement à la cinquième étape E4 , le procédé selon l'invention réinitialise le premier et le deuxième compteur C1, C2 à une valeur nulle si la batterie est capable de répondre à une sollicitation électrique prédéterminée Z3, c'est-à-dire que le couple de valeurs est dans la troisième zone Z3.

Ainsi le procédé prend en compte le fait que, entre deux roulages successifs, le conducteur a pu recharger la batterie 4.

On notera que la détection préalable de la transition du signal d'autorisation AUT-OK de faux à vrai E41, E42, E43 à toute incrémentation ou mise à zéro du premier compteur C1 et du deuxième compteur C2 permet d'être certain que, grâce à la première temporisation, l'unique couple de valeurs représentatives Ur, Rr déterminé soit pertinent, c'est-à-dire par exemple :
- l'unique couple de valeurs représentatives Ur, Rr retenu est le couple de valeur de la dernière sollicitation du train de sollicitations, le statut STATUT étant resté à l'état fiable STF pour chaque sollicitation sans apparition du défaut interne de l'unité de contrôle 10 ou
- l'unique couple de valeurs représentatives Ur, Rr retenu est la moyenne des valeurs de chacune des sollicitations du train de sollicitations, le statut STATUT étant resté à l'état fiable STF pour chaque sollicitation sans apparition du défaut interne de l'unité de contrôle 10 ou
- l'unique couple de valeurs représentatives Ur, Rr retenu est le couple de valeur de la dernière sollicitation du train de sollicitations avec le statut STF, ce statut ayant changé pour la sollicitation suivante.

Consécutivement à la cinquième étape E4, le procédé exécute une sixième étape E5 émettant une alerte maximale AL-MAX si le premier compteur C1 est supérieur ou égal à un premier seuil prédéterminé SEUIL 1, ou le deuxième compteur C2 est supérieur ou égal à un deuxième seuil prédéterminé SEUIL 22.

Cette sixième étape E5 émet une alerte intermédiaire AL-MED si le deuxième compteur C2 est supérieur ou égal à un troisième seuil prédéterminé SEUIL 2, et est strictement inférieur au deuxième seuil prédéterminé SEUIL 22, et le premier compteur C1 est strictement inférieur au premier seuil prédéterminé SEUIL 1.

En variante, consécutivement à la cinquième étape E4, le procédé exécute la sixième étape E5 émettant l'alerte maximale AL-MAX si :
- le début de cette sixième étape E5 se trouve dans une fenêtre temporelle DUREE comprise entre le début de l'exécution de la deuxième sous étape et l'arrêt du véhicule, et si
- le signal d'autorisation AUT-OK est vrai, et si
- le premier compteur C1 est supérieur ou égal au premier seuil prédéterminé SEUIL 1, ou le deuxième compteur C2 est supérieur ou égal au deuxième seuil prédéterminé SEUIL 22.

En variante, cette sixième étape E5 émet une alerte intermédiaire AL-MED si :
- le début de cette sixième étape E5 se trouve dans la fenêtre temporelle DUREE comprise entre le début de l'exécution de la deuxième sous étape et l'arrêt du véhicule, et si
- le signal d'autorisation AUT-OK est vrai, et si
- le deuxième compteur C2 est supérieur ou égal au troisième seuil prédéterminé SEUIL 2, et est strictement inférieur au deuxième seuil prédéterminé SEUIL 22, et le premier compteur C1 est strictement inférieur au premier seuil prédéterminé SEUIL 1.

On notera que, avantageusement, l'alerte intermédiaire AL-MED et l'alerte alerte maximale AL-MAX sont maintenue jusqu'à la mise hors tension du véhicule, voire jusqu'à l'endormissement des calculateurs du véhicule (mise hors tension des calculateurs).

On peut noter, à titre d'exemple de seuils :
- le premier seuil prédéterminé SEUIL 1 est à une valeur de 1,
- le deuxième seuil prédéterminé SEUIL 22 est à une valeur de 2,
- le troisième seuil prédéterminé SEUIL 2 est à une valeur de 1.

Ainsi le procédé permet de distinguer plusieurs niveaux d'alerte correspondants à plusieurs niveaux de gravité. L'alerte maximale AL-MAX sera émise lorsque la batterie 4 est identifiée comme présentant un risque élevé pour la sécurité du conducteur et des passagers. L'alerte intermédiaire AL-MED sera émise lorsque la batterie 4 est identifiée comme présentant un risque moyen pour la sécurité du conducteur et des passagers.

Selon l'alerte émise, le procédé exécutera des actions différentes. Par exemple :

si l'alerte maximale AL-MAX est émise, le procédé :
- active une information de stop à l'intention du conducteur, et/ou
- active un voyant fixe relatif à la batterie pour inciter le conducteur à faire examiner cette batterie 4, et/ou
- active une coupure d'alimentation d'un consommateur électrique prédéfini comme non prioritaire par rapport à d'autres consommateurs, notamment une fonction de confort vis-à-vis d'une fonction sécuritaire.

Le procédé peut en outre limiter la vitesse du véhicule, voire immobiliser le véhicule si, parés une durée déterminée, l'alerte maximale est toujours vraie (émise).

Cette fonction de confort est par exemple le chauffage électrique d'un siège ou de l'habitacle du véhicule au-delà d'une température de dégivrage,

Si l'alerte intermédiaire AL-MED est émise, le procédé active une information de service à l'intention du conducteur pour l'inciter à minima à recharger la batterie 4.

Les informations sont par exemple des voyants au tableau de bord, des alarmes sonores, ou encore des messages diffusés sur un écran d'un ordinateur de bord.

Cette invention permet de disposer avantageusement sur des véhicules électriques, une amélioration de la sécurité du conducteur et des passagers, en testant au démarrage la capacité de la batterie 4 à assurer les fonctions sécuritaires qui lui sont allouées.

Cette invention est d'autant plus avantageuse que sur un véhicule électrique, la phase de démarrage du moteur thermique qui permet généralement d'imposer une forte sollicitation électrique à la batterie 4 et donc de la tester, n'existe plus.

Ainsi ce procédé permet d'une part, de déterminer la capacité réelle d'une batterie à fournir la puissance nécessaire au bon fonctionnement de fonctions sécuritaires, comme une direction assistée par exemple, en réalisant systématiquement un test représentatif en début de roulage, dont le résultat permet d'être robuste aux différentes variables auxquelles peut être soumis la batterie, telles que son état de charge, sa température, son niveau de vieillissement, d'endommagement ou même de connexion au réseau de bord. D'autre part ce procédé permet d'alerter le client par une information claire sans être intrusif dans l'utilisation du véhicule.

En outre, ce procédé confirme, si nécessaire, cette capacité réelle d'une batterie à fournir la puissance nécessaire au bon fonctionnement de fonctions sécuritaires sur plusieurs roulages successifs, de façon à fournir à l'utilisateur une information d'alerte fiable, sur le danger auquel il est exposé.

Par ailleurs, ce procédé agit préventivement, en réduisant l'énergie électrique consommée par la batterie, de façon à prioriser la puissance disponible dans la batterie pour les fonctions sécuritaires.

Un autre avantage de ce procédé est que via ce test réalisé et l'analyse du résultat, la capacité réelle de la batterie à alimenter la fonction sécuritaire sera connue : en effet, il est possible par exemple d'avoir une batterie bien chargée, à 90% par exemple, et de tout de même la diagnostiquer via ce procédé comme présentant un risque, il suffit tout simplement pour cela que la batterie soit très vieille ou simplement endommagée et son état de charge est alors trompeur. En revanche, le procédé de l'invention provoque une sollicitation représentative (mise en situation) de la batterie et l'analyse du résultat par ce procédé tel que décrit donnera la meilleure photo possible sur ce que la batterie est réellement capable de faire.

## Revendications

1. Procédé de contrôle d'une batterie (4) d'un véhicule comprenant la batterie (4) et une unité de contrôle (10) mettant en œuvre le procédé, ce procédé exécutant :
- une étape de diagnostic (E0, E1, E2, E3) de la batterie (4), après un démarrage du véhicule et pour chaque roulage du véhicule, ce diagnostic donnant un état parmi trois états (Z1, Z2, Z3) de la batterie (4) possibles:
- la batterie est capable de répondre à une sollicitation électrique prédéterminée (Z3), ou
- la batterie n'est pas capable de répondre à cette sollicitation électrique prédéterminée (Z1) ou
- une incertitude demeure à répondre à cette sollicitation électrique prédéterminée (Z2), et consécutivement à l'étape de diagnostic, le procédé exécute une cinquième étape (E4) consistant à incrémenter d'une valeur de 1 un premier compteur (C1) si la batterie n'est pas capable de répondre à cette sollicitation électrique prédéterminée (Z1), ou à incrémenter d'une valeur de 1 un deuxième compteur (C2) si l'incertitude demeure à répondre à cette sollicitation électrique prédéterminée (Z2), cette cinquième étape (E4) réinitialisant le premier et le deuxième compteur (C1, C2) à une valeur nulle si la batterie est capable de répondre à une sollicitation électrique prédéterminée (Z3), **caractérisé en ce que** consécutivement à la cinquième étape (E4), le procédé exécute une sixième étape (E5) émettant une alerte maximale (AL-MAX) si le premier compteur (C1) est supérieur ou égal à un premier seuil prédéterminé (SEUIL 1), ou le deuxième compteur (C2) est supérieur ou égal à un deuxième seuil prédéterminé (SEUIL 22).

2. Procédé selon la revendication 1, **caractérisé en ce que** cette sixième étape (E5) émet une alerte intermédiaire (AL-MED) si le deuxième compteur (C2) est supérieur ou égal à un troisième seuil prédéterminé (SEUIL 2), et est strictement inférieur au deuxième seuil prédéterminé (SEUIL 22), et le premier compteur (C1) est strictement inférieur au premier seuil prédéterminé (SEUIL 1).

3. Procédé selon la revendication 1 ou 2, **caractérisé en ce que** si l'alerte maximale (AL-MAX) est émise, le procédé :
- active une information de stop à l'intention du conducteur, et/ou
- active un voyant fixe relatif à la batterie (4) pour inciter le conducteur à faire examiner cette batterie (4), et/ou
- active une coupure d'alimentation d'un consommateur électrique prédéfini comme non prioritaire par rapport à d'autres consommateurs, notamment une fonction de confort vis-à-vis d'une fonction sécuritaire.

4. Procédé selon la revendication 2, **caractérisé en ce que** si l'alerte intermédiaire (AL-MED) est émise, le procédé active une information de service à l'intention du conducteur pour l'inciter à minima à recharger la batterie (4).

## Patentansprüche

1. Verfahren zum Steuern einer Batterie (4) eines Fahrzeugs, das die Batterie (4) und eine das Verfahren implementierende Steuereinheit (10) umfasst, wobei dieses Verfahren ausführt:
- einen Diagnoseschritt (EO, E1, E2, E3) der Batterie (4) nach dem Starten des Fahrzeugs und bei jeder Fahrt des Fahrzeugs, wobei diese Diagnose einen von drei möglichen Zuständen (Z1, Z2, Z3) der Batterie (4) ergibt:
- die Batterie in der Lage ist, auf einen vorgegebenen Strombedarf zu reagieren (Z3), oder
- die Batterie ist nicht in der Lage, diesen vorgegebenen Strombedarf zu decken
(Z1) oder
- eine Unsicherheit hinsichtlich der Beantwortung dieser vorgegebenen elektrischen Anforderung (Z2) verbleibt, und im Anschluss an den Diagnoseschritt führt das Verfahren einen fünften Schritt (E4) aus, der darin besteht, einen ersten Zähler (C1) um den Wert 1 zu erhöhen, wenn die Batterie nicht in der Lage ist, auf diese vorgegebene elektrische Anforderung (Z1) zu reagieren, oder Inkrementieren eines zweiten Zählers (C2) um einen Wert von 1, wenn die Unsicherheit hinsichtlich der Beantwortung dieser vorgegebenen elektrischen Anforderung (Z2) bestehen bleibt, wobei dieser fünfte Schritt (E4) das Zurücksetzen des ersten und zweiten Zählers (C1, C2) auf einen Nullwert umfasst, wenn die Batterie in der Lage ist, auf eine vorgegebene elektrische Anforderung (Z3) zu antworten, **dadurch gekennzeichnet, dass** das Verfahren im Anschluss an den fünften Schritt (E4) einen sechsten Schritt ausführt (E5) Ausgeben einer Maximalwarnung (AL-MAX), wenn der erste Zähler (C1) größer oder gleich einem ersten vorgegebenen Schwellenwert (SCHWELLE 1) ist oder der zweite Zähler (C2) größer oder gleich einem zweiten vorgegebenen Schwellenwert (SCHWELLE 22) ist.

2. Verfahren nach Anspruch 1, **dadurch gekennzeichnet, dass** dieser sechste Schritt (E5) einen Zwischenalarm (AL-MED) ausgibt, wenn der zweite Zähler (C2) größer oder gleich einen dritten vorgegebenen Schwellenwert (SCHWELLENWERT 2) und ist strikt kleiner als der zweite vorgegebene Schwellenwert (SCHWELLENWERT 22), und der erste Zähler (C1) ist strikt kleiner als der erste vorgegebene Schwellenwert (SCHWELLENWERT 1).

3. Verfahren nach Anspruch 1 oder 2, **dadurch gekennzeichnet, dass** bei Ausgabe des maximalen Alarms (AL-MAX) das Verfahren:
- aktiviert Haltestelleninformationen für den Fahrer und/oder
- eine dauerhaft leuchtende Kontrollleuchte für die Batterie (4) aktiviert, um den Fahrer aufzufordern, diese Batterie (4) überprüfen zu lassen, und/oder
- Aktiviert die Stromabschaltung eines elektrischen Verbrauchers, der vorab als nicht prioritär gegenüber anderen Verbrauchern definiert wurde, insbesondere eine Komfortfunktion gegenüber einer Sicherheitsfunktio.

4. Verfahren nach Anspruch 2, **dadurch gekennzeichnet, dass** bei Erreichen des Zwischenalarms (AL- MED) werden Serviceinformationen für den Fahrer aktiviert, um ihn zumindest zum Aufladen der Batterie zu animieren (4).

## Claims

1. Method for controlling a battery (4) of a vehicle comprising the battery (4) and a control unit (10) implementing the method, this method executing:
- a diagnostic step (EO, EI, E2, E3) of the battery (4), after starting the vehicle and for each trip of the vehicle, this diagnostic giving one of three possible states (Z1, Z2, Z3) of the battery (4):
- the battery is capable of responding to a predetermined electrical demand (Z3), or
- the battery is not able to respond to this predetermined electrical demand (Z1) or
- an uncertainty remains in responding to this predetermined electrical request (Z2), and following the diagnostic step, the method executes a fifth step (E4) consisting of incrementing a first counter (C1) by a value of 1 if the battery is not capable of responding to this predetermined electrical request (Z1), or
incrementing a second counter (C2) by a value of 1 if the uncertainty remains in responding to this predetermined electrical request (Z2), this fifth step (E4) resetting the first and second counters (C1, C2) to a zero value if the battery is capable of responding to a predetermined electrical request (Z3), **characterized in that** following the fifth step (E4), the method executes a sixth step
(E5) issuing a maximum alert (AL-MAX) if the first counter (C1) is greater than or equal to a first predetermined threshold (THRESHOLD 1), or the second counter (C2) is greater than or equal to a second predetermined threshold (THRESHOLD 22).

2. Method according to claim 1, **characterized in that** this sixth step (E5) emits an intermediate alert (AL-MED) if the second counter (C2) is greater than or equal to
a third predetermined threshold (THRESHOLD 2), and is strictly less than the second predetermined threshold (THRESHOLD 22), and the first counter (C1) is strictly less than the first predetermined threshold (THRESHOLD 1).

3. Method according to claim 1 or 2, **characterized in that** if the maximum alert (AL-MAX) is issued, the method:
- activates stop information for the driver, and/or
- activates a fixed indicator light relating to the battery (4) to encourage the driver to have this battery (4) examined, and/or
- activates a power cut of an electrical consumer predefined as not having priority over other consumers, in particular a comfort function versus a safety function.

4. Method according to claim 2, **characterized in that** if the intermediate alert (AL-MED) is issued, the process activates service information for the driver to at least encourage him to recharge the battery (4).
